(19) **Europäisches Patentamt / European Patent Office / Office européen des brevets**

(11) **EP 4 730 428 A1**

(12) **EUROPEAN PATENT APPLICATION**
published in accordance with Art. 153(4) EPC

(43) Date of publication:
**22.04.2026 Bulletin 2026/17**

(21) Application number: **24908011.0**

(22) Date of filing: **17.12.2024**

(51) International Patent Classification (IPC):
*H01M 4/36* (2006.01)     *H01M 4/525* (2010.01)
*H01M 4/505* (2010.01)     *H01M 4/131* (2010.01)
*H01M 10/052* (2010.01)     *C01G 53/00* (2025.01)
*C30B 29/22* (2006.01)     *H01M 4/02* (2006.01)

(52) Cooperative Patent Classification (CPC):
**C01G 53/00; C30B 29/22; H01M 4/02; H01M 4/131; H01M 4/36; H01M 4/505; H01M 4/525; H01M 10/052; H01M 10/0525; Y02E 60/10**

(86) International application number:
**PCT/KR2024/020493**

(87) International publication number:
**WO 2025/135728 (26.06.2025 Gazette 2025/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:   22.12.2023   KR 20230190391
08.10.2024   KR 20240137158

(71) Applicant: **LG Energy Solution, Ltd.**
**Seoul 07335 (KR)**

(72) Inventors:
- **CHO, Hyeon Jin**
  **Daejeon 34122 (KR)**
- **BAEK, So Ra**
  **Daejeon 34122 (KR)**
- **JU, Ji Young**
  **Daejeon 34122 (KR)**
- **YOO, Dong Wan**
  **Daejeon 34122 (KR)**
- **JO, Chi Ho**
  **Daejeon 34122 (KR)**

(74) Representative: **Hoffmann Eitle**
**Patent- und Rechtsanwälte PartmbB**
**Arabellastraße 30**
**81925 München (DE)**

(54) **POSITIVE ELECTRODE ACTIVE MATERIAL, METHOD FOR PREPARING SAME, AND POSITIVE ELECTRODE AND LITHIUM SECONDARY BATTERY COMPRISING SAME**

(57) A positive electrode active material according to the present invention is a positive electrode active material including a lithium nickel-based oxide particle in the form of a single particle composed of one single nodule or in the form of a pseudo-single particle, which is a composite of 40 or fewer nodules, and a coating layer formed on the surface of the lithium nickel-based oxide particle, wherein when the positive electrode active material is analyzed by X-ray diffraction, A defined by Equation 1 below is 1.2% to 3.7%.

$A = \{$(Area of peak in region in which diffraction angle $2\theta$ is 37.1° to 37.9°)/(Area of peak in region in which diffraction angle $2\theta$ is 36.0° to 37.1°)$\} \times 100$.     [Equation 1]

EP 4 730 428 A1

**(Cont. next page)**

FIG. 1

**Description**

## TECHNICAL FIELD

**Cross-reference to Related Applications**

This application claims the benefit of Korean Patent Application No. 10-2023-0190391, filed on December 22, 2023, and Korean Patent Application No. 10-2024-0137158, filed on October 8, 2024, in the Korean Intellectual Property Office, the disclosures of which are incorporated herein in their entirety.

**Technical Field**

The present invention relates to a positive electrode active material, a method for preparing the same, and a positive electrode and a lithium secondary battery including the same.

## BACKGROUND ART

A lithium secondary battery is generally composed of a positive electrode, a negative electrode, a separator, and an electrolyte, and the positive electrode and the negative electrode include active materials capable of intercalation and deintercalation of lithium ions.

As a positive electrode active material of the lithium secondary battery, a lithium cobalt oxide ($LiCoO_2$), a lithium nickel oxide ($LiNiO_2$), a lithium manganese oxide ($LiMnO_2$, $LiMnO_4$, or the like), a lithium iron phosphate compound ($LiFePO_4$), and the like have been used. In order to compensate for problems of lithium transition metal oxides including Ni, Co, or Mn alone, lithium composite transition metal oxides including two or more transition metals have been developed, and among them, a lithium nickel cobalt manganese oxide including Ni, Co, and Mn is widely used in the field of electric vehicle batteries.

A typical lithium nickel cobalt manganese oxide is generally in the form of a spherical secondary particle in which tens to hundreds of primary particles are aggregated. However, in the case of applying a lithium nickel cobalt manganese oxide in the form of a secondary particle in which a large number of primary particles are aggregated, particle breakage easily occurs wherein primary particles are broken off during a roll-pressing process when manufacturing a positive electrode, and there is a problem in that cracks are generated inside particles during a charging and discharging process. When particles of a positive electrode active material are broken or cracked, the contact area with an electrolyte solution increases, so that gas generation and active material deterioration caused by a side reaction with the electrolyte solution increase, resulting in a problem in that lifespan properties are degraded.

In order to solve the above problems, a technique for producing a positive electrode active material in the form of a single particle rather than a secondary particle by increasing a firing temperature when preparing a lithium nickel cobalt manganese oxide has been proposed. A positive electrode active material in the form of a single particle has a smaller contact area with an electrolyte solution compared to a typical positive electrode active material in the form of a secondary particle, and thus, has fewer side reactions with the electrolyte solution, and has excellent particle strength, so that there is less particle breakage when manufacturing an electrode. Therefore, when a positive electrode active material in the form of a single particle is applied, there are advantages in terms of gas generation and lifespan properties.

However, a typical positive electrode active material in the form of a single particle type requires a high firing temperature during synthesis, and accordingly, there is a problem in that the crystal structure of the surface of a particle changes from a layered structure to a rock-salt structure. The surface of the rock-salt structure, which is a non-conductor, has a problem in that the surface interferes with the movement of lithium ions during charging and discharging, thereby degrading the lifespan of the battery.

Therefore, there is a need for the development of a positive electrode active material applied with the shape of a coating layer optimized for a surface in order to reduce gas generation and improve lifespan properties.

## DISCLOSURE OF THE INVENTION

## TECHNICAL PROBLEM

An aspect of the present invention is to provide a positive electrode active material, a method for preparing the same, and a positive electrode and a lithium secondary battery including the same, wherein the shape of a cobalt coating layer on the surface of a lithium nickel-based oxide in the form of a single particle is optimized to reduce gas generation and improve high-temperature lifespan properties.

## TECHNICAL SOLUTION

[1] According to an aspect of the present invention, provided is a positive electrode active material including a lithium nickel-based oxide particle in the form of a single particle composed of one single nodule or in the form of a pseudo-single particle, which is a composite of 40 or fewer nodules, and a coating layer formed on the surface of the lithium nickel-based oxide particle, wherein when the positive electrode active material is analyzed by X-ray diffraction, A defined by Equation 1 below is 1.2% to 3.7%.

A = {(Area of peak in region in which diffraction angle 2θ is 37.1° to 37.9°)/(Area of peak in region in which diffraction angle 2θ is 36.0° to 37.1°)} × 100    [Equation 1]

[2] The present invention provides positive electrode active material according to [1] above, wherein the area of a peak in a region in which a diffraction angle 2θ is 36.0° to 37.1° may be 120 to 160.
[3] The present invention provides the positive electrode active material according to at least one of [1] or [2], wherein the area of a peak in a region in which a diffraction angle 2θ is 37.1° to 37.9° may be 1 to 5.
[4] The present invention provides the positive electrode active material according to at least one of [1] to [3], wherein the coating layer may have a form including both a dot shape and a film.
[5] The present invention provides the positive electrode active material according to at least one of [1] to [4], wherein the coating layer may include Co.
[6] The present invention provides the positive electrode active material according to at least one of [1] to [5], wherein the coating layer may further include one or more selected from the group consisting of B, Ti, Mg, Al, Zr, Y, Ba, Ca, Zn, Sr, W, Ta, Nb, and Mo.
[7] The present invention provides the positive electrode active material according to at least one of [1] to [6], The positive electrode active material may have a $D_{50}$ of 3.0 μm to 5.0 μm.
[8] The present invention provides the positive electrode active material according to at least one of [1] to [7], wherein the positive electrode active material may have a BET specific surface area of 0.4 m$^2$/g to 1.0 m$^2$/g.
[9] The present invention provides the positive electrode active material according to at least one of [1] to [8], wherein the lithium nickel-based oxide may have a composition represented by Formula 1 below.

[Formula 1]     $Li_aNi_bCo_cM^1_dM^2_eO_2$

In Formula 1 above, M$^1$ may be at least one selected from the group consisting of Mn and Al, M$^2$ may be at least one selected from the group consisting of Ba, Ca, Zr, Ti, Mg, Ta, Nb, and Mo, and it may be that 0.8≤a≤1.5, 0.8≤b≤1.0, 0≤c≤0.2, 0≤d≤0.2, and 0≤e≤0.2.
[10] According to an aspect of the present invention, provided is a method for preparing a positive electrode active material, the method including mixing a transition metal precursor including nickel, cobalt, and manganese with a lithium raw material, and then firing the mixture to prepare a lithium nickel-based oxide, and mixing the lithium nickel-based oxide with cobalt, and then subjecting the mixture to primary coating under the temperature of 450 °C to 600 °C and secondary coating under the temperature of 600 °C to 850 °C to prepare a positive electrode active material including a coating layer on the surface of the lithium nickel-based oxide, wherein the lithium nickel-based oxide is in the form of a single particle composed of one single nodule or in the form of a pseudo-single particle, which is a composite of 40 or fewer nodules, and when the positive electrode active material is analyzed by X-ray diffraction, A defined by Equation 1 below is 1.2% to 3.7%.

A = {(Area of peak in region in which diffraction angle 2θ is 37.1° to 37.9°)/(Area of peak in region in which diffraction angle 2θ is 36.0° to 37.1°)} × 100    [Equation 1]

[11] The present invention provides method for preparing a positive electrode active material according to [10] above, wherein the primary coating and the secondary coating are performed for 1 to 10 hours.
[12] The present invention provides a positive electrode comprising the positive electrode active material according to any one of [1] to [9].
[13] The present invention provides a lithium secondary battery comprising the positive electrode of [12].

## ADVANTAGEOUS EFFECTS

A positive electrode active material according to the present invention optimizes the shape of a cobalt-containing coating layer on the surface of a lithium nickel-based oxide in the form of a single particle, and thus, may reduce side reactions with an electrolyte solution, thereby reducing gas generation, and may improve high-temperature lifespan properties.

## BRIEF DESCRIPTION OF THE DRAWINGS

FIG. 1 is a scanning electron microscope (SEM) image of positive electrode active materials prepared according to Example 1 of the present invention.
FIG. 2 is a scanning electron microscope (SEM) image of positive electrode active materials prepared according to Example 2 of the present invention.
FIG. 3 is a scanning electron microscope (SEM) image of positive electrode active materials prepared according to Comparative Example 1 of the present invention.
FIG. 4 is a scanning electron microscope (SEM) image of positive electrode active materials prepared according to Comparative Example 2 of the present invention.
FIG. 5 is a graph showing the results of XRD analysis for the positive electrode active materials prepared by Examples 1 to 2 and Comparative Examples 1 to 2 of the present invention.

## MDOE FOR CARRYING OUT THE INVENTION

It will be understood that terms or words used in the present specification and claims shall not be construed as being limited to having meanings defined in commonly used dictionaries, but should be interpreted as having meanings and concepts consistent with the technical idea of the present invention based on the principle that an inventor may appropriately define concepts of the terms to best explain the invention.
The terms used herein are for the purpose of describing embodiments and are not intended to be limiting of the present invention. In the present specification, singular forms include plural forms unless the context clearly indicates otherwise. As used herein, the terms "comprises" and/or "comprising" are intended to be inclusive of the stated elements, and do not exclude the possibility of the presence or the addition of one or more other elements.
In the present specification, when a portion is said to include a certain component, it means that the portion may further include another component rather than excluding another component unless otherwise stated.
In the present specification, "%" means wt% unless otherwise noted.
In the present invention, a "single particle" is a particle composed of one single nodule.
In the present invention, a "pseudo-single particle" refers to a composite particle formed of 40 or fewer nodules.
In the present invention, a "nodule" refers to a particle unit body constituting a single particle and a pseudo-single particle, wherein the nodule may be a single crystal with no crystalline grain boundaries, or may be a polycrystal with no grain boundaries in appearance when observed in a range of vision of 5,000 to 20,000 times using a scanning electron microscope (SEM). The average particle diameter of the nodule may be measured as an arithmetic average value of particle diameters of each nodule measured using a scanning electron microscope (SEM).
In the present invention, a "secondary particle" refers to a particle formed by the agglomeration of a plurality of tens to hundreds of primary particles. More specifically, the secondary particle is an agglomerate more than 40 primary particles.
The term "particle" used in the present invention may include any one or all of a single particle, a pseudo-single particle, a primary particle, a nodule, and a secondary particle.
In the present invention, "$D_{50}$" refers to an average particle size based on 50% of a volume cumulative particle size distribution of positive electrode active material. The $D_{50}$ may be measured by a laser diffraction method. For example, the average particle diameter (D50) may be measured by dispersing positive electrode active material powder in a dispersion medium, and then introducing the mixture into a commercially available laser diffraction particle size measurement device (e.g., Microtrac MT 3000) to be irradiated with an ultrasonic wave of about 28 kHz to an output of 60W, thereby obtaining a volume cumulative particle size distribution graph, and then obtaining a particle size corresponding to 50% of a volume cumulative amount.
In the present invention, the "specific surface area" is measured by a BET method, and specifically, may be calculated from the adsorption amount of nitrogen gas under a liquid nitrogen temperature (77K) using Belsorp-mino II of BEL Japan Co.
In order to develop a positive electrode active material in the form of a single particle having excellent high-temperature lifespan properties, the present inventors have repeatedly conducted research and found that if a positive electrode active material subjected to primary and secondary coating in different temperature ranges from each other, thereby having A, an area ratio of a peak in a specific diffraction angle range, adjusted to satisfy a specific range during X-ray diffraction (XRD) analysis is applied, a coating layer satisfies an optimized shape, so that it is possible to reduce side reactions with an electrolyte solution, thereby reducing gas generation and at the same time, to implement high-temperature lifespan properties, and have completed the present invention.

**Positive electrode active material**

A positive electrode active material according to the present invention is a positive electrode active material including a lithium nickel-based oxide particle in the form of a single particle composed of one single nodule or in the form of a pseudo-single particle, which is a composite of 40 or fewer nodules, and a coating layer formed on the surface of the lithium nickel-based oxide particle, wherein when the positive electrode active material is analyzed by X-ray diffraction, A defined by Equation 1 below is 1.2 to 3.7.

$$A = \{(\text{Area of peak in region in which diffraction angle } 2\theta \text{ is } 37.1° \text{ to } 37.9°)/(\text{Area of peak in region in which diffraction angle } 2\theta \text{ is } 36.0° \text{ to } 37.1°)\} \times 100 \qquad \text{[Equation 1]}$$

At this time, an X-ray diffraction analysis pattern was obtained by performing measurement with measurement conditions set to $2\theta$ ranges of 36.0° to 37.1° and 37.1° to 37.9° and 40 kV based on Cu-K$\alpha$ radiation.

Referring to A defined by Equation 1 above, it is possible to identify the shape of a coating layer optimized for the surface of a lithium nickel-based oxide in the form of a single particle, and if a A value satisfies the above-described range, the coating layer may have a shape including both a dot shape and a film.

Specifically, the peak in the region where the diffraction angle $2\theta$ is from 37.1° to 37.9° corresponds to the LiCoO$_2$ (hereinafter referred to as LCO) phase on the (101) crystal plane of the lithium nickel-based oxide particle, which mainly reflects a thin and uniform coating layer in the form of a film. Meanwhile, the peak in the region where the diffraction angle $2\theta$ is from 36.0° to 37.1° mainly reflects an LCO phase in the form of dots. When the value of A is in the range of 1.2 to 3.7, it indicates that the peak intensities in the two regions are relatively balanced. In other words, it suggests that both the film-type phase in the 37.1° to 37.9° region and the dot-type phase in the 36.0° to 37.1° region are present. Accordingly, since the coating layer includes both dot and film forms, side reactions between the lithium nickel-based oxide surface and the electrolyte can be suppressed, resulting in reduced gas generation and improved high-temperature cycle life characteristics by protecting the surface of the lithium nickel-based oxide. Preferably, the value of A may be from 1.5 to 3.5, from 2.0 to 3.5, or from 2.1 to 3.3.

In Equation 1 above, it is possible to identify a coating form having a LiCoO$_2$ (hereinafter, LCO) phase on the surface of the lithium nickel-based oxide particle from the area of a peak in a region in which the diffraction angle $2\theta$ is 37.1° to 37.9°. The area of a peak at the diffraction angle $2\theta$ of 37.1° to 37.9° may be 1 to 5, preferably 1 to 4, and more preferably 1.5 to 3.5. When the above range is satisfied, it indicates that a thin and uniform film structure is formed, which leads to an improvement in ion mobility.

In Equation 1 above, it is possible to identify a coating form on a crystal plane of a lithium nickel-based oxide particle 101 from the area of a peak in a region in which the diffraction angle $2\theta$ is 36.0° to 37.1°. The area of a peak at the diffraction angle $2\theta$ of 36.0° to 37.1° may be 120 to 160, 120 to 150, 130 to 150, or 130 to 145. When the above range is satisfied, it also indicates that a dot-shaped structure is formed. The dot shape increases the surface area, thereby shortening the migration path of lithium ions and enhancing the electrochemical reaction rate.

If the area of a peak satisfies each of the above-described ranges, a cobalt coating layer on the surface of the lithium nickel-based oxide particle includes a dot shape and a film, so that there is a surface protection effect (passivation), and an effect of improving output properties by a dot-shaped LCO phase.

The present invention includes a lithium nickel-based oxide particle in which the molar ratio of Ni among all transition metals is 80 mol% or greater, preferably 90 mol% or greater. When the molar ratio of Ni satisfies the above-described range, excellent capacity properties may be implemented.

The lithium nickel-based oxide particle is in the form of a single particle composed of one single nodule or in the form of a pseudo-single particle, which is a composite of 40 or fewer nodules, preferably 2 to 30 nodules, more preferably 2 to 20 nodules. The lithium nickel-based oxide in the form of a single particle and/or a pseudo-single particle has higher particle strength than a typical lithium nickel-based oxide in the form of a secondary particle in which tens to hundreds of primary particles are aggregated, so that there is less particle breakage during roll-pressing.

In addition, the lithium nickel-based oxide in the form of a single particle or a pseudo-single particle according to the present invention has a small number of sub-components (i.e., nodules) constituting a particle, so that there is less change caused by volume expansion and contraction of primary particles during charging and discharging, and accordingly, the occurrence of cracks inside the particle is significantly reduced.

The positive electrode active material according to the present invention includes a coating layer formed on the surface of the lithium nickel-based oxide. The coating layer may include cobalt (Co). The coating layer including cobalt suppresses deterioration of the positive electrode active material during a charging and discharging process of a battery, so that high-temperature lifespan properties are improved.

The content of cobalt included in the coating layer may be 1 mol% to 5 mol%, preferably 1 mol% to 4 mol%, and more preferably 1 mol% to 3 mol%, based on 100 mol% of the lithium nickel-based oxide. If the content of cobalt included in the coating layer is less than 1 mol% based on 100 moles of the lithium nickel-based oxide, there is a problem in that a high-temperature lifespan is deteriorated due to the lack of a cobalt coating amount, and if greater than 5 mol%, the amount of nickel contributing to a capacity among the all transition metals decreases, so that there may be a problem in that a charging capacity is decreased.

The coating layer may further include at least one selected from the group consisting of Al, Mg, Ti, V, Cr, Mn, Zr, Nb, W, and B other than Co. The coating layer may preferably include Co and B. If the coating layer additionally includes B other than Co, the effect of improving the capacity may be more excellent than the case in which the coating layer includes only the cobalt.

Meanwhile, the positive electrode active material according to the present invention may include a lithium nickel-based oxide having a composition as shown in Formula 1 below.

$$[\text{Formula 1}] \qquad Li_aNi_bCo_cM^1_dM^2_eO_2$$

In Formula 1 above, $M^1$ is Mn, Al, or a combination thereof, preferably Mn or a combination of Mn and Al, and $M^2$ is one or more selected from the group consisting of Ba, Ca, Zr, Ti, Mg, Ta, Nb, and Mo. An $M^2$ element is not necessarily included, but if included in an appropriate amount, the $M^1$ element may serve to promote particle growth during firing, or to improve crystal structure stability.

The a represents the molar ratio of lithium in the lithium-nickel-based oxide, and may satisfy $0.8 \leq a \leq 1.5$, $0.8 \leq a \leq 1.2$, $0.9 \leq a \leq 1.1$, or $0.95 \leq a \leq 1.15$. When the molar ratio of lithium satisfies the above-described range, a stable layered crystal structure may be formed.

The b represents the molar ratio of nickel among all metals except for lithium in the lithium nickel-based oxide, and may satisfy $0.8 \leq b \leq 1.0$, $0.8 \leq b < 1.0$, $0.85 \leq b < 1.0$, or $0.9 \leq b < 1.0$. If the molar ratio of nickel satisfies the above-described range, excellent capacity properties may be exhibited, and particularly, if the molar ratio of nickel is 0.9 or greater, more excellent capacity properties may be implemented.

The c represents the molar ratio of cobalt among all metals except for lithium in the lithium nickel-based oxide, and may satisfy $0 \leq c \leq 0.2$, $0 < c < 0.2$, or $0 < c < 0.18$.

The d represents the molar ratio of $M^1$ among all metals except for lithium in the lithium nickel-based oxide, and may satisfy $0 \leq d \leq 0.2$, $0 < d < 0.2$, or $0 < d < 0.18$.

The e represents the molar ratio of an $M^2$ element among all metals except for lithium in the lithium nickel-based oxide, and may satisfy $0 \leq e \leq 0.2$, $0 \leq e \leq 0.15$, or $0 \leq e \leq 0.1$.

The positive electrode active material according to the present invention may have a $D_{50}$ of 3.0 $\mu$m to 5.0 $\mu$m, 3.5 $\mu$m to 5.0 $\mu$m, or 4.0 $\mu$m to 4.5 $\mu$m. If the $D_{50}$ of the positive electrode active material according to the present invention satisfies the above-described range, properties of high energy density and low initial resistance may be implemented. If the $D_{50}$ of the positive electrode active material is less than 3.0 $\mu$m, the content of fine powder increases, so that there may be problems such as increased resistance or generation of a high-temperature storage gas, and if the $D_{50}$ is greater than 5.0 $\mu$m, there may be problems with capacity and initial output.

The positive electrode active material according to the present invention may have a BET specific surface area of 0.4 $m^2$/g to 1.0 $m^2$/g, 0.4 $m^2$/g to 0.8 $m^2$/g, or 0.4 $m^2$/g to 0.7 $m^2$/g. If the BET specific surface area of the positive electrode active material is too low, the reaction area with an electrolyte is insufficient, so that it is difficult to implement sufficient capacity, and if the specific surface area is too high, moisture absorption is fast, and a side reaction with the electrolyte is accelerated, so that it is difficult to secure lifespan properties.

## Method for preparing positive electrode active material

Next, a method for preparing a positive electrode active material of the present invention will be described.

When preparing a positive electrode active material having an Ni molar ratio of 80 mol% or greater among all transition metals, due to a high firing temperature, the surface structure completeness of the positive electrode active material may be low, and the concentration of residual lithium may be high. Therefore, there is a need for a technique capable of improving the surface structure completeness by means of a coating layer formed on the surface of a lithium nickel-based oxide particle, reducing the concentration of residual lithium, and improving resistance properties by means of optimization of coating conditions.

The method of preparing a positive electrode active material according to the present invention includes mixing a transition metal precursor including nickel, cobalt, and manganese with a lithium raw material, and then firing the mixture to prepare a lithium nickel-based oxide, and mixing the lithium nickel-based oxide with cobalt, and then subjecting the mixture to primary coating under the temperature of 450 °C to 600 °C and secondary coating under the temperature of 600 °C to 850 °C to prepare a positive electrode active material including a coating layer on the surface of the lithium nickel-based oxide.

the lithium nickel-based oxide is in the form of a single particle composed of one single nodule or in the form of a pseudo-single particle, which is a composite of 40 or fewer nodules, and when the positive electrode active material is analyzed by X-ray diffraction, A defined by Equation 1 below is 1.2% to 3.7%. Since the above description is equally applied, a redundant description will be omitted.

$$A = \{(\text{Area of peak in region in which diffraction angle } 2\theta \text{ is } 37.1° \text{ to } 37.9°)/(\text{Area of peak in region in which diffraction angle } 2\theta \text{ is } 36.0° \text{ to } 37.1°)\} \times 100 \qquad \text{[Equation 1]}$$

Hereinafter, each step of the method for preparing a positive electrode active material will be described in detail.

First, a transition metal precursor including nickel, cobalt, and manganese is mixed with a lithium raw material and fired to form a lithium nickel-based oxide.

At this time, the transition metal precursor may be a commercially available precursor purchased and used, such as a nickel-cobalt-manganese-based hydroxide or the like, or may be prepared according to a precursor preparation method known in the art, such as coprecipitation.

For example, a transition metal-containing solution including cations of nickel (Ni), cobalt (Co), and $M^1$ is prepared, and then the transition metal-containing solution is added with an ammonium cation-containing complex forming agent and a basic aqueous solution to be subjected to a coprecipitation reaction to prepare a transition metal precursor.

The transition metal-containing solution may include a nickel-containing raw material, a cobalt-containing raw material, and an $M^1$-containing raw material, and the $M^1$-containing raw material may be a manganese-containing raw material and/or an aluminum-containing raw material.

The nickel-containing raw material may be, for example, an acetate, a nitrate, a sulfate, a halide, a sulfide, a hydroxide, an oxide, an oxyhydroxide, or the like, which contains nickel, and may be, specifically, $Ni(OH)_2$, $NiO$, $NiOOH$, $NiCO_3 \cdot 2Ni(OH)_2 \cdot 4H_2O$, $NiC_2O_2 \cdot 2H_2O$, $Ni(NO_3)_2 \cdot 6H_2O$, $NiSO_4$, $NiSO_4 \cdot 6H_2O$, a fatty acid nickel salt, a nickel halide, or a combination thereof, but is not limited thereto.

The cobalt-containing raw material may be an acetate, a nitrate, a sulfate, a halide, a sulfide, a hydroxide, an oxide, or an oxyhydroxide, and the like, all containing cobalt, specifically $Co(OH)_2$, $CoOOH$, $Co(OCOCH_3)_2 \cdot 4H_2O$, $Co(NO_3)_2 \cdot 6H_2O$, $CoSO_4$, $Co(SO_4)_2 \cdot 7H_2O$, or a combination thereof, but is not limited thereto.

The manganese-containing raw material may be, for example, an acetate, a nitrate, a sulfate, a halide, a sulfide, a hydroxide, an oxide, an oxyhydroxide, or a combination thereof, which contains manganese, and may be, specifically, a manganese oxide such as $Mn_2O_3$, $MnO_2$, and $Mn_3O_4$, a manganese salt such as $MnCO_3$, $Mn(NO_3)_2$, $MnSO_4$, manganese acetate, dicarboxylic acid manganese, citric acid manganese, and fatty acid manganese salt, manganese oxyhydroxide, manganese chloride, or a combination thereof, but is not limited thereto.

The aluminum-containing raw material may be, for example, $Al_2O_3$, $Al(OH)_3$, $Al(NO_3)_3$, $Al_2(SO_4)_3$, $(HO)_2AlCH_3CO_2$, $HOAl(CH_3CO_2)_2$, $Al(CH_3CO_2)_3$, an aluminum halide, or a combination thereof.

The transition metal-containing solution may be prepared by adding the nickel-containing raw material, the cobalt-containing raw material, and the $M^1$-containing raw material to a solvent, specifically water, or to a mixed solvent of water and an organic solvent which can be uniformly mixed with water (for example, alcohol, etc.), or may be prepared by mixing an aqueous solution of the nickel-containing raw material, an aqueous solution of the cobalt-containing raw material, and an aqueous solution of the $M^1$-containing raw material.

The ammonium cation-containing complex forming agent may be, for example, $NH_4OH$, $(NH_4)_2SO_4$, $NH_4NO_3$, $NH_4Cl$, $CH_3COONH_4$, $NH_4CO_3$, or a combination thereof, but is not limited thereto. Meanwhile, the ammonium cation-containing complex forming agent may be used in the form of an aqueous solution, and at this time, water, or a mixture of an organic solvent (for example, an alcohol, etc.) which can be uniformly mixed with water and water may be used as a solvent.

The basic compound may be a hydroxide of an alkali metal or an alkaline earth metal, such as $NaOH$, $KOH$ or $Ca(OH)_2$, a hydrate thereof, or a combination thereof. The basic compound may also be used in the form of an aqueous solution, and at this time, as a solvent, water, or a mixture of an organic solvent (for example, alcohol, etc.) which can be uniformly mixed with water and water may be used.

The basic compound is added to control the pH of a reaction solution, and may be added in an amount such that the pH of a metal solution is 8 to 12.

The coprecipitation reaction may be performed in an inert atmosphere, for example, in a nitrogen atmosphere, an argon atmosphere, or the like, at a temperature in the range of 35 °C to 80 °C.

By the above-described process, positive electrode active material particles of a nickel-cobalt-$M^1$ hydroxide are produced, and precipitated in the reaction solution. By controlling the concentration of the nickel-containing raw material, the cobalt-containing raw material, and the $M^1$-containing raw material, it is possible to prepare a positive electrode active material precursor having a nickel (Ni) content of 80 mol% or greater of the total content of metals. The precipitated positive electrode active material precursor particles are separated according to a typical method, and dried to prepare a positive electrode active material precursor.

Thereafter, the transition metal precursor and a lithium raw material may be mixed.

The lithium raw material may be a sulfate, a nitrate, an acetate, a carbonate, an oxalate, a citrate, a halide, a hydroxide, an oxyhydroxide, or the like, which contains lithium, and is not particularly limited as long as it may be dissolved in water. Specifically, the lithium raw material may be $Li_2CO_3$, $LiNO_3$, $LiNO_2$, LiOH, $LiOH \cdot H_2O$, LiH, LiF, LiCl, LiBr, LiI, $CH_3COOLi$, $Li_2O$, $Li_2SO_4$, $CH_3COOLi$, $Li_3C_6H_5O_7$, or the like, and any one thereof or a mixture of two or more thereof may be used.

The transition metal precursor and the lithium raw material may be mixed such that the molar ratio of Li to the total metals in the transition metal precursor is 1.2:1, 1.15:1, or 1.1:1. When the mixing ratio of the lithium raw material to the transition metal precursor is within the above range, a positive electrode active material having a well-developed layered crystal structure can be produced, resulting in excellent capacity characteristics and structural stability.

Thereafter, the mixture may be calcined. The calcination may be performed under an air or oxygen atmosphere. In order to form a single-particle type lithium nickel-based oxide, calcination must be performed at a higher temperature than that used for the conventional secondary-particle type lithium nickel-based oxide. For example, when the precursor composition is the same, the calcination temperature should be approximately 30°C to 100°C higher than the temperature used for preparing the conventional secondary-particle type lithium nickel-based oxide. The calcination temperature for producing a single-particle type lithium nickel-based oxide may vary depending on the metal composition of the precursor. For example, when preparing a high-nickel (High-Ni) single-particle type lithium nickel-based oxide containing 80 mol% or more of nickel (Ni), the calcination may be performed at a temperature of 800°C to 1000°C, 800°C to 950°C, or 850°C to 950°C. When the calcination temperature is within the above range, a single-particle type lithium nickel-based oxide with excellent electrochemical properties can be produced.

In addition, the calcination may be performed for 6 to 35 hours, 6 to 20 hours, or 10 to 20 hours. When the calcination time is within the above range, a single-particle type lithium nickel-based oxide can be formed.

Next, the lithium nickel-based oxide is mixed with cobalt, and then the mixture is subjected to primary coating and secondary coating to form a positive electrode active material including a coating layer on the surface of the lithium nickel-based oxide. The primary coating is characterized by being performed at a temperature of 450 °C to 600 °C, and the secondary coating is performed at a temperature of 600 °C to 850 °C.

Residual lithium by-products present on the surface of a lithium nickel-based oxide particle may include lithium hydroxide (LiOH), lithium carbonate ($Li_2CO_3$), and the like. If a coating process is performed in two steps, and the coating process is performed in a low-temperature region during primary coating, a LCO phase may be formed in a thin film on the surface by a reaction with lithium hydroxide (LiOH) having a relatively low melting point. Thereafter, if the coating process is performed in a high-temperature region during secondary coating, a LCO phase in the form of a dot may be formed on the surface by a reaction with lithium carbonate ($Li_2CO_3$) having a high melting point, and the LCO phase may serve as LCO capable of implementing high-output properties.

Preferably, the primary coating may be performed at a temperature of 450 °C to 550 °C, 465 °C to 535 °C or 480 °C to 520 °C. When the primary coating is performed at a temperature below 450°C, a preliminary reaction between the lithium nickel-based oxide and cobalt may be insufficient, which can lead to agglomeration and result in the formation of a non-uniform coating layer. On the other hand, when the primary coating is performed at a temperature exceeding 550°C, excessive heat may damage the layered structure, also leading to the formation of a non-uniform coating layer.

Preferably, the secondary coating may be performed at a temperature of 600 °C to 800 °C, 650 °C to 800 °C or 650 °C to 750 °C. When the secondary coating is performed at a temperature below 600°C, an increased number of dot-shaped structures may form on the surface, increasing the area of uncoated regions on the lithium nickel-based oxide surface, which may lead to inferior long-term high-temperature performance. If the secondary coating is performed at a temperature higher than 800 °C, rather than forming a thin LCO phase on the surface, both lithium hydroxide (LiOH) and lithium carbonate ($Li_2CO_3$) may all melt and enter the lithium nickel-based oxide particle, which is difficult to form a uniform coating layer.

The primary coating may be performed for 1 hour to 10 hours, 1 hour to 7 hours, or 2 hours to 6 hours.

The secondary coating may be performed for 1 hour to 10 hours, 2 hours to 9 hours, or 3 hours to 8 hours. When the durations of the primary coating and the secondary coating are within the above-defined ranges, a coating layer comprising both dot-shaped and film-type structures can be formed. As a result, side reactions between the lithium nickel-based oxide surface and the electrolyte can be suppressed, thereby reducing gas generation and improving high-temperature cycle life characteristics by protecting the surface of the lithium nickel-based oxide.

For example, the surface of the lithium nickel-based oxide particle is coated by a cobalt compound. For example, the cobalt compound may be one or more among $Co(OH)_2$, $CoOOH$, $Co(OCOCH_3)_2.4H_2O$, $Co(NO_3)_2.6H_2O$, $CoSO_4$, and $Co(SO_4)_2.7H_2O$.

## Positive electrode

The positive electrode according to the present invention includes the above-described positive electrode active material of the present invention. Specifically, the positive electrode includes a positive electrode current collector, and a positive electrode active material layer formed on the positive electrode current collector, wherein the positive electrode active material layer includes the positive electrode active material according to the present invention. Since the positive electrode active material has been described above, a detailed description thereof will be omitted, and hereinafter, only the rest of the components will be described in detail.

The positive electrode current collector may include a highly conductive metal, and is not particularly limited as long as it is not reactive in a voltage range of a battery while a positive electrode active material layer is able to be easily adhered to the positive electrode current collector. As the positive electrode current collector, for example, stainless steel, aluminum, nickel, titanium, heat treatment carbon, or aluminum or stainless steel that is surface-treated with one of carbon, nickel, titanium, silver, and the like may be used. Also, the positive electrode current collector may typically have a thickness of 3 $\mu$m to 500 $\mu$m, and microscopic irregularities may be formed on the surface of the current collector to improve the adhesion of the positive electrode active material. For example, the positive electrode current collector may be used in various forms such as a film, a sheet, a foil, a net, a porous body, a foam, a non-woven body, and the like.

The positive electrode active material layer may selectively include, if necessary, a conductive material and a binder together with the positive electrode active material.

At this time, the positive electrode active material may be included in a content of 80 wt% to 99 wt%, more specifically 90 wt% to 98 wt% with respect to the total weight of the positive electrode active material layer.

The conductive material is used to impart conductivity to an electrode, and any conductive material may be used without particular limitation as long as it has electron conductivity without causing a chemical change in a battery to be constituted. Specific examples thereof may include graphite such as natural graphite or artificial graphite; a carbon-based material such as carbon black, acetylene black, Ketjen black, channel black, furnace black, lamp black, thermal black, and carbon fiber; metal powder or metal fiber of such as copper, nickel, aluminum, and silver; a conductive tube such as a carbon nanotube; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be included in an amount of 0.01 wt% to 10 wt%, preferably 0.1 wt% to 9 wt%, and more preferably 0.1 wt% to 5 wt% based on the total weight of a positive electrode active material layer.

The binder serves to improve the bonding between positive electrode active material particles and the adhesion between the positive electrode active material and the current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, polymethymethaxrylate, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated EPDM, styrene-butadiene rubber (SBR), fluorine rubber, a poly acrylic acid, a polymer having the hydrogen thereof substituted with Li, Na, or Ca, or various copolymers thereof, and any one thereof or a mixture of two or more thereof may be used. The binder may be included in an amount of 1 wt% to 30 wt%, preferably 1 wt% to 20 wt%, and more preferably 1 wt% to 10 wt% based on the total weight of a positive electrode active material layer.

The positive electrode may be manufactured according to a typical method for manufacturing a positive electrode except that the positive electrode active material described above is used. Specifically, the positive electrode may be manufactured by applying a positive electrode slurry composition, which is prepared by dissolving or dispersing the positive electrode active material described above and selectively, if necessary, a binder, a conductive material, and a dispersant in a solvent, on a positive electrode current collector, followed by drying and roll-pressing.

The solvent may be a solvent commonly used in the art, and may be dimethyl sulfoxide (DMSO), isopropyl alcohol, N-methylpyrrolidone (NMP), dimethyl formamide (DMF), acetone, water, or the like, and any one thereof or a mixture of two or more thereof may be used. The amount of the solvent to be used is sufficient if the solvent dissolves or disperses the positive electrode active material, the conductive material, the binder, and the dispersant in consideration of the coating thickness of a slurry, and a manufacturing yield, and thereafter, allows the slurry to have a viscosity capable of exhibiting excellent thickness uniformity when applied for manufacturing the positive electrode.

In addition, in another method, the positive electrode may also be manufactured by casting the positive electrode slurry composition on a separate support, and then laminating a film obtained by being peeled off from the support on a positive electrode current collector.

## Lithium secondary battery

Next, the lithium secondary battery according to the present invention will be described.

Specifically, the lithium secondary battery includes a positive electrode, a negative electrode positioned to face the positive electrode, a separator interposed between the positive electrode and the negative electrode, and an electrolyte, and since the positive electrode is the same as that described above, a detailed description thereof will be omitted, and hereinafter, only the rest of the components will be described in detail.

Also, the lithium secondary battery may selectively further include a battery case for accommodating an electrode assembly of the positive electrode, the negative electrode, and the separator, and a sealing member for sealing the battery case.

In the lithium secondary battery, the negative electrode includes a negative electrode current collector and a negative electrode active material layer positioned on the negative electrode current collector.

The negative electrode current collector is not particularly limited as long as it has high conductivity without causing a chemical change in a battery, and for example, copper, stainless steel, aluminum, nickel, titanium, heat-treated carbon, copper or stainless steel that is surface-treated with one of carbon, nickel, titanium, silver, and the like, an aluminum-cadmium alloy, and the like may be used. Also, the negative electrode current collector may typically have a thickness of 3 $\mu$m to 500 $\mu$m, and as in the case of the positive electrode current collector, microscopic irregularities may be formed on the surface of the current collector to improve the adhesion of a negative electrode active material. For example, the negative electrode current collector may be used in various forms such as a film, a sheet, a foil, a net, a porous body, a foam, and a non-woven body.

The negative electrode active material layer selectively includes a binder and a conductive material in addition to a negative electrode active material.

As the negative electrode active material, a compound capable of reversible intercalation and de-intercalation of lithium may be used. Specific examples thereof may include a carbonaceous material such as artificial graphite, natural graphite, graphitized carbon fiber, and amorphous carbon; a metallic compound alloyable with lithium such as Si, Al, Sn, Pb, Zn, Bi, In, Mg, Ga, Cd, an Si alloy, an Sn alloy, or an Al alloy; a metal oxide which may be doped and undoped with lithium such as $SiO\beta(0 < \beta < 2)$, $SnO_2$, a vanadium oxide, and a lithium vanadium oxide; or a composite including the metallic compound and the carbonaceous material such as an Si-C composite or an Sn-C composite, and any one thereof or a mixture of two or more thereof may be used. In addition, a metal lithium thin film may be used as the negative electrode active material. In addition, low crystalline carbon, high crystalline carbon, and the like may all be used as a carbon material. Representative examples of the low crystalline carbon may include soft carbon and hard carbon, and representative examples of the high crystalline carbon may include irregular, planar, flaky, spherical, or fibrous natural graphite or artificial graphite, Kish graphite, pyrolytic carbon, mesophase pitch-based carbon fiber, meso-carbon microbeads, mesophase pitches, and high-temperature heat-treated carbon such as petroleum or coal tar pitch derived cokes.

The negative electrode active material may be included in an amount of 80 wt% to 99 wt%, 82 wt% to 99 wt%, or 84 wt% to 99 wt% based on the total weight of the negative electrode active material layer.

The binder is a component for assisting in bonding between a conductive material, an active material, and a current collector, and is typically added in an amount of 0.1 wt% to 10 wt% based on the total weight of a negative electrode active material layer. Examples of the binder may include polyvinylidene fluoride (PVDF), polyvinyl alcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated-EPDM, styrene-butadiene rubber, nitrile-butadiene rubber, fluorine rubber, various copolymers thereof, and the like.

The conductive material is a component for further improving the conductivity of a negative electrode active material, and may be included in an amount of 1 wt% to 30 wt%, 1 wt% to 20 wt%, or 1 wt% to 10 wt% based on the total weight of the negative electrode active material layer. The conductive material is not particularly limited as long as it has conductivity without causing a chemical change in the battery, and for example, graphite such as natural graphite or artificial graphite; carbon black such as acetylene black, Ketjen black, channel black, furnace black, lamp black, and thermal black; conductive fiber such as carbon fiber and metal fiber; fluorinated carbon; metal powder such as aluminum powder and nickel powder; a conductive whisker such as zinc oxide and potassium titanate; a conductive metal oxide such as titanium oxide; and a conductive material such as a polyphenylene derivative, or the like may be used.

The negative electrode active material layer may be prepared by applying a negative electrode slurry composition, which is prepared by dissolving or dispersing a negative electrode active material and selectively, a binder and a conductive material in a solvent, on a negative electrode current collector, followed by drying, or may be prepared by casting the negative electrode slurry composition on a separate support, and then laminating a film peeled off from the support on a negative electrode current collector.

Meanwhile, in the lithium secondary battery, the separator is to separate the negative electrode and the positive electrode and to provide a movement path for lithium ions, and any separator may be used without particular limitation as long as it is a separator commonly used in a lithium secondary battery, and particularly, a separator having high moisture-retention capability for an electrolyte solution while having low resistance to the movement of electrolyte ions is preferable. Specifically, a porous polymer film, for example, a porous polymer film manufactured using a polyolefin-based polymer such as an ethylene homopolymer, a propylene homopolymer, an ethylene/butene copolymer, an ethylene/hexene copolymer, or an ethylene/methacrylate copolymer, or a stacked structural body having two or more layers thereof may be used. In addition, a typical porous non-woven fabric, for example, a non-woven fabric made of glass fiber having a high melting point, polyethylene terephthalate fiber, or the like may be used. Also, a coated separator including a ceramic component or a polymer material may be used to secure heat resistance or mechanical strength, and may selectively be used in a single-layered or multi-layered structure.

In addition, the electrolyte used in the present invention may be an organic liquid electrolyte, an inorganic liquid electrolyte, a solid polymer electrolyte, a gel-type polymer electrolyte, a solid inorganic electrolyte, a molten-type inorganic electrolyte, or the like, all of which may be used in the manufacturing of a lithium secondary battery, but the electrolyte is not limited thereto.

Specifically, the electrolyte may include an organic solvent and a lithium salt.

As the organic solvent, any organic solvent may be used without particular limitation as long as it can serve as a medium through which ions involved in an electrochemical reaction of a battery may move. Specifically, as the organic solvent, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; a carbonate-based solvent such as dimethyl carbonate (DMC), diethyl carbonate (DEC), methylethyl carbonate (MEC), ethylmethyl carbonate (EMC), ethylene carbonate (EC), and propylene carbonate (PC); an alcohol-based solvent such as ethyl alcohol and isopropyl alcohol; nitriles such as R-CN (wherein R is a linear, branched, or cyclic C2 to C20 hydrocarbon group and may include a double-bond aromatic ring or ether bond); amides such as dimethylformamide; dioxolanes such as 1,3-dioxolane; or sulfolanes may be used. Among the above, the carbonate-based solvent is preferred, and a mixture of a cyclic carbonate (e.g., ethylene carbonate or propylene carbonate) having high ion conductivity and a high dielectric constant, which may increase charge/discharge performance of the battery, and a low-viscosity linear carbonate-based compound (e.g., ethylmethyl carbonate, dimethyl carbonate, diethyl carbonate, or the like) is more preferred.

Any compound may be used as the lithium salt without particular limitation as long as it is a compound capable of providing lithium ions used in a lithium secondary battery. Specifically, anions of the lithium salt may be at least one selected from the group consisting of $F^-$, $Cl^-$, $Br^-$, $I^-$, $NO_3^-$, $N(CN)_2^-$, $BF_4^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$, and as the lithium salt, $LiPF_6$, $LiClO_4$ $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, $LiCl$, $LiI$, $LiB(C_2O_4)_2$, or the like may be used. The lithium salt may be used in a concentration range of 0.1M M to 4.0 M, preferably 0.5 M to 3.0 M, and more preferably 1.0 M to 2.0 M. If the concentration of the lithium salt is included in the above-described range, the electrolyte has suitable conductivity and viscosity, and thus, may exhibit excellent electrolyte performance, and lithium ions may effectively move.

In the electrolyte, in order to improve the lifespan properties of a battery, to suppress the decrease in battery capacity, and to improve the discharge capacity of the battery, one or more additives, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, and the like may be further included other than the above electrolyte components. At this time, the additive may be included in an amount of 0.1 wt% to 10.0 wt% based on the total weight of the electrolyte.

The lithium secondary battery including the positive electrode active material according to the present invention as describe above stably exhibits excellent discharging capacity, output properties, and capacity retention rate, and thus, are useful for portable devices such as a mobile phone, a notebook computer, and a digital camera, and in the field of electric cars such as a hybrid electric vehicle (HEV).

Accordingly, according to another embodiment of the present invention, a battery module including the lithium secondary battery as a unit cell, and a battery pack including the battery module are provided.

The battery module or the battery pack may be used as a power source for a power tool, an electric car including an electric vehicle (EV), a hybrid electric vehicle, and a plug-in hybrid electric vehicle (PHEV), or one or more medium-to-large devices in a system for power storage.

Hereinafter, embodiments of the present invention will be described in detail so that those skilled in the art may easily carry out the present invention. However, the present invention may be embodied in many different forms, and is not limited to the embodiments set forth herein.

## Examples and Comparative Examples

**Example 1**

A single-particle type lithium nickel-based oxide having a composition of $LiNi_{0.85}Co_{0.05}Mn_{0.1}O_2$ was prepared by mixing $Ni_{0.85}Co_{0.05}Mn_{0.1}(OH)_2$ and LiOH at a molar ratio of Li : (Ni + Co + Mn) = 1.1 : 1, followed by calcination at 890°C for 15 hours.

Thereafter, the single-particle type lithium nickel-based oxide was mixed with $Co(OH)_2$ at a weight ratio of 100 : 0.2, and subjected to a primary coating at 500°C for 3 hours and a secondary coating at 720°C for 6 hours, thereby producing a positive electrode active material having a surface coating layer containing cobalt.

**Example 2**

Positive electrode active material was prepared in the same manner as in Example 1, except that the primary coating was performed at 550 °C for 3 hours, and then the secondary coating was performed at 680 °C for 6 hours.

**Comparative Example 1**

Positive electrode active material was prepared in the same manner as in Example 1, except that the primary coating was performed at 500 °C for 3 hours, and then the secondary coating was performed at 880 °C for 6 hours.

**Comparative Example 2**

Positive electrode active material was prepared in the same manner as in Example 1, except that the primary coating was performed at 500 °C for 3 hours, and then the secondary coating was performed at 570 °C for 6 hours.

**Experimental Example 1. Observation of surface of positive electrode active material**

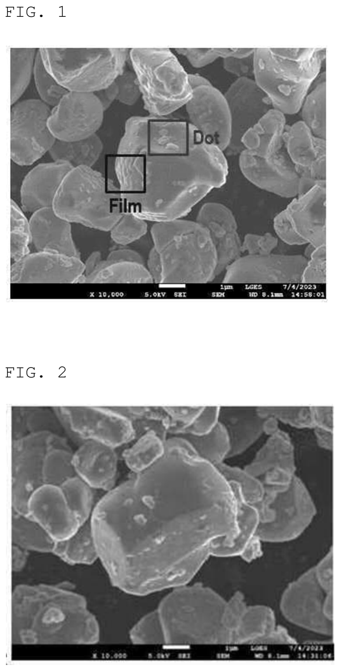

SEM images of the positive electrode active material respectively prepared in Examples 1 to 2 and Comparative Examples 1 to 2 were obtained using a scanning electron microscope device. The SEM images are shown in FIGS. 1 to 4.

Referring to FIGS. 1 and 2, it can be confirmed that the positive electrode active materials prepared in Examples 1 and 2 include a cobalt coating layer present in both a dot shape and a film.

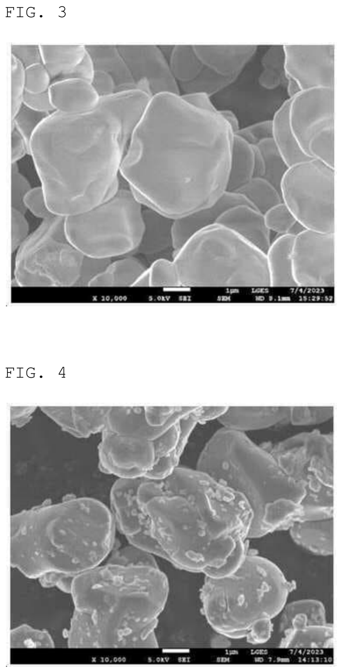

On the other hand, referring to FIGS. 3 and 4, it can be confirmed that the positive electrode active material prepared in Comparative Example 1 was subjected to the secondary coating at a higher temperature than in the Examples, causing excessive reaction between cobalt and lithium hydroxide (LiOH), which has a relatively low melting point, resulting in the coating layer being present only in a film form. In the case of the positive electrode active material prepared in Comparative Example 2, the secondary coating was performed at a lower temperature than in the Examples, leading to excessive reaction between cobalt and lithium carbonate ($Li_2CO_3$), which has a higher melting point, resulting in the coating layer being present only in a dot shape.

**Experimental Example 2: Measurement of $D_{50}$ of positive electrode active material**

0.005 g of each of the positive electrode active materials prepared in Examples 1 and 2 and Comparative Examples 1 and 2 was dispersed in a dispersion medium $H_2O$, and then introduced into a commercially available laser diffraction particle size measuring device (for example, Microtrac MT 3000) and irradiated with an about 28 kHz ultrasonic wave to an output of 60 W to obtain a volume cumulative particle size distribution graph of each of the positive electrode active materials, and a $D_{50}$ value was obtained using the graph. The $D_{50}$ is a particle diameter at a point at which the cumulative distribution is 50% in the volume cumulative particle size distribution graph of the positive electrode active material. The measurement results are shown in [Table 1] below.

[Table 1]

| | $D_{50}$ [$\mu$m] |
|---|---|
| Example 1 | 4.2 |
| Example 2 | 4.1 |
| Comparative Example 1 | 4.4 |
| Comparative Example 2 | 4.1 |

## Experimental Example 3: XRD analysis of positive electrode active material

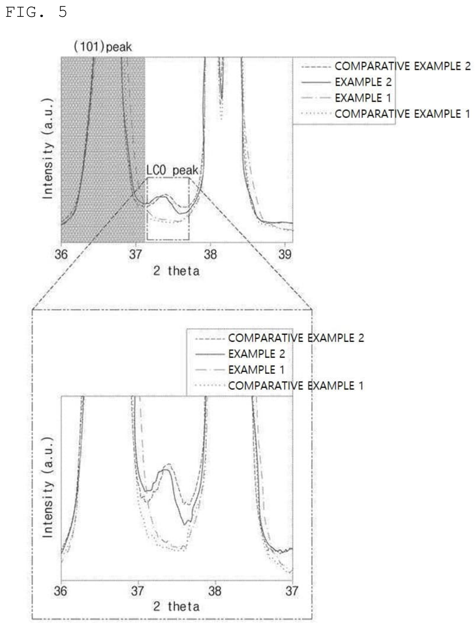

In order to compare and analyze the coating layers included in the positive electrode active materials prepared in Examples 1 and 2 and Comparative Examples 1 and 2, XRD analysis was performed on each positive electrode active material by using D8_Endeavor of Bruker Co., and the results are shown in FIG. 5.

Referring to FIG. 5, in the cases of Example 1 and Comparative Example 1, the difference between the primary coating temperature and the secondary coating temperature is large, and thus a significant change in peak intensity can be observed. in the cases of Example 2 and Comparative Example 2, the difference between the primary and secondary coating temperatures is small, resulting in a relatively small change in peak intensity.

At this point, since the pattern and intensity of the peaks observed in XRD vary depending on the temperature, simply evaluating the presence or absence of peaks only confirms the presence of the LCO phase. Accordingly, the inventors evaluated the area of the peaks within a specific diffraction angle $2\theta$ region to identify the coating form on the (101) crystal plane of the lithium nickel-based oxide particles depending on temperature variation

Specifically, an X-ray diffraction analysis pattern was obtained by performing measurement with measurement conditions set to a $2\theta$ range of 35° to 50° based on Cu-K$\alpha$ radiation. In the final analysis data, it is possible to identify a coating form on a crystal plane of the lithium nickel-based oxide particle 101 by the area of a peak at a $2\theta$ of 36.0° to 37.1°. In addition, it is possible to identify a coating form having a $LiCoO_2$ (hereinafter, LCO) phase on the surface of the lithium nickel-based oxide particle by the area of a peak at a $2\theta$ of 37.1° to 37.9°. Each A defined by Equation 1 below was calculated and shown in [Table 2] below.

$$A = \{(\text{Area of peak in region in which diffraction angle } 2\theta \text{ is } 37.1° \text{ to } 37.9°)/(\text{Area of peak in region in which diffraction angle } 2\theta \text{ is } 36.0° \text{ to } 37.1°)\} \times 100 \qquad \text{[Equation 1]}$$

[Table 2]

| | Area of peak in region in which diffraction angle $2\theta$ is 36.0° to 37.1° | Area of peak in region in which diffraction angle $2\theta$ is 37.1° to 37.9° | A [%] |
|---|---|---|---|
| Example 1 | 145.4 | 3.21 | 2.21 |
| Example 2 | 143.7 | 4.48 | 3.12 |
| Comparative Example 1 | 150.6 | 1.66 | 1.10 |
| Comparative Example 2 | 141.6 | 5.49 | 3.88 |

## Experimental Example 4: Electrochemical characteristics of lithium secondary battery

The positive electrode active materials of Examples 1 and 2 and Comparative Examples 1 and 2 were used to manufacture lithium secondary batteries as follows, and the lithium secondary batteries were evaluated for high-temperature lifespan properties and resistance properties. The measurement results are shown in [Table 3] below.

### <Manufacturing of lithium secondary battery>

The positive electrode active material prepared in each of Examples 1 to 2 and Comparative Examples 1 to 2, a conductive material (carbon black), and a PVDF binder were mixed at a weight ratio of 95 : 2 : 3 in N-methylpyrrolidone to prepare a positive electrode slurry. The positive electrode slurry was applied on one surface of an aluminum current collector, dried at 130 °C, and then roll-pressed to manufacture a positive electrode.

A negative active material (graphite (artificial: natural) = 50: 50 weight ratio), a conductive material (carbon nanotube), and a binder (styrene-butadiene rubber (SBR) were mixed in water at a weight ratio of 95.5 : 1.0 : 3.5 to prepare a negative electrode slurry. The negative electrode slurry was applied on a copper current collector sheet, dried, and then roll-pressed to manufacture a negative electrode.

A separator was interposed between the positive electrode and the negative electrode manufactured by the method described above to manufacture an electrode assembly, and the electrode assembly was placed inside a battery case, and then an electrolyte solution was injected into the case to manufacture a battery cell. The electrolyte solution was prepared by dissolving $LiPF_6$ with a 0.6 M concentration in a mixed organic solvent in which ethylene carbonate (EC): dimethyl carbonate (DMC): ethyl methyl carbonate (EMC) were mixed at a volume ratio of 1 : 2 : 1, and then adding 2 wt% of vinylene carbonate (VC) thereto.

Specifically, for each of the lithium secondary battery cells, charging and discharging were performed at 45 °C under the condition of 0.1 C/0.1 C at a voltage range of 2.5 V to 4.2 V, which was set to one cycle, and a capacity retention rate and a resistance increase rate at the 300-th cycle were measured.

[Table 3]

|  | Capacity retention ratio [%] | Resistance increas e rate [%] |
|---|---|---|
| Example 1 | 85.8 | 85.1 |
| Example 2 | 84.5 | 92.0 |
| Comparative Example 1 | 79.1 | 116.5 |
| Comparative Example 2 | 82.1 | 110.9 |

Referring to Table 3 above, it can be confirmed that the lithium secondary batteries to which the positive electrode active materials of Examples 1 to 2 in which A defined by Equation 1 satisfies the range of the present invention during XRD analysis are applied have a high capacity retention rate and a low resistance increase rate compared to the lithium secondary batteries to which the positive electrode active materials of Comparative Examples 1 and 2 are applied, and thus, have excellent high-temperature lifespan properties and resistance properties.

**Experimental Example 5: Gas generation amount measurement**

Each lithium secondary battery manufactured above was charged to 4.2 V with 0.33 C in a CC-CV mode, and then the secondary battery was dissembled to separate the positive electrode. Then, 400 mg of the positive electrode and 400 μL of an electrolyte solution were put into a pouch-type battery case, and the battery case was sealed to manufacture a cell, and the cell was stored at 60 °C for 8 weeks to measure the change in cell volume (ΔCell volume, unit: mL) before and after the high-temperature storage. The cell volume change was measured by placing the cell in water and then measuring the volume change of the water. The measurement results are shown in [Table 4] below.

[Table 4]

|  | Gas generation amount [mL] |
|---|---|
| Example 1 | 0.25 |
| Example 2 | 0.25 |
| Comparative Example 1 | 0.37 |
| Comparative Example 2 | 0.43 |

Referring to [Table 4] above, it can be confirmed that the lithium secondary batteries to which the positive electrode active materials of Examples 1 to 2 in which A defined by Equation 1 satisfies the range of the present invention during XRD analysis are applied have reduced gas generation compared to the lithium secondary batteries to which the positive electrode active materials of Comparative Examples 1 and 2 are applied.

**Claims**

1. A positive electrode active material comprising: a lithium nickel-based oxide particle in the form of a single particle composed of one single nodule or in the form of a pseudo-single particle, which is a composite of 40 or fewer nodules; and a coating layer formed on the surface of the lithium nickel-based oxide particle,
   wherein
   when the positive electrode active material is analyzed by X-ray diffraction, A defined by Equation 1 below is 1.2% to 3.7%:

   A = {(Area of peak in region in which diffraction angle 2θ is 37.1° to 37.9°)/(Area of peak in region in which diffraction angle 2θ is 36.0° to 37.1°)} × 100   [Equation 1]

2. The positive electrode active material of claim 1, wherein the area of a peak in a region in which a diffraction angle 2θ is 36.0° to 37.1° is 120 to 160.

3. The positive electrode active material of claim 1, wherein the area of a peak in a region in which a diffraction angle 2θ is 37.1° to 37.9° is 1 to 5.

4. The positive electrode active material of claim 1, wherein the coating layer has a form including both a dot shape and a film.

5. The positive electrode active material of claim 1, wherein the coating layer comprises Co.

6. The positive electrode active material of claim 5, wherein the coating layer further comprises one or more selected from the group consisting of B, Ti, Mg, Al, Zr, Y, Ba, Ca, Zn, Sr, W, Ta, Nb, and Mo.

7. The positive electrode active material of claim 1, wherein the positive electrode active material has a $D_{50}$ of 3.0 μm to 5.0 μm.

8. The positive electrode active material of claim 1, wherein the positive electrode active material has a BET specific surface area of 0.4 $m^2$/g to 1.0 $m^2$/g.

9. The positive electrode active material of claim 1, wherein the lithium nickel-based oxide has a composition represented by Formula 1 below:

   [Formula 1]     $Li_aNi_bCo_cM^1_dM^2_eO_2$

   wherein in Formula 1 above, $M^1$ is at least one selected from the group consisting of Mn and Al, $M^2$ is at least one selected from the group consisting of Ba, Ca, Zr, Ti, Mg, Ta, Nb, and Mo, and 0.8≤a≤1.5, 0.8≤b≤1.0, 0≤c≤0.2, 0≤d≤0.2, and 0≤e≤0.2.

10. A method for preparing a positive electrode active material, the method comprising:

    mixing a transition metal precursor including nickel, cobalt, and manganese with a lithium raw material, and then firing the mixture to prepare a lithium nickel-based oxide; and
    mixing the lithium nickel-based oxide with cobalt, and then subjecting the mixture to primary coating under the temperature of 450 °C to 600 °C and secondary coating under the temperature of 600 °C to 850 °C to prepare a positive electrode active material including a coating layer on the surface of the lithium nickel-based oxide, wherein:

    the lithium nickel-based oxide is in the form of a single particle composed of one single nodule or in the form of a pseudo-single particle, which is a composite of 40 or fewer nodules; and
    when the positive electrode active material is analyzed by X-ray diffraction, A defined by Equation 1 below is 1.2% to 3.7%:

    A = {(Area of peak in region in which diffraction angle 2θ is 37.1° to 37.9°)/(Area of peak in region in which diffraction angle 2θ is 36.0° to 37.1°)} × 100     [Equation 1]

11. A method for preparing a positive electrode active material according to claim 10, wherein the primary coating and the secondary coating are performed for 1 to 10 hours

12. A positive electrode comprising the positive electrode active material according to any one claim of claims 1 to 9.

13. A lithium secondary battery comprising the positive electrode of claim 12.

FIG. 1

FIG. 2

FIG. 3

FIG. 4

FIG. 5

## INTERNATIONAL SEARCH REPORT

| International application No. |
| --- |
| **PCT/KR2024/020493** |

| A. | CLASSIFICATION OF SUBJECT MATTER |
| --- | --- |

**H01M 4/36**(2006.01)i; **H01M 4/525**(2010.01)i; **H01M 4/505**(2010.01)i; **H01M 4/131**(2010.01)i; **H01M 10/052**(2010.01)i; **C01G 53/00**(2006.01)i; **C30B 29/22**(2006.01)i; **H01M 4/02**(2006.01)i

According to International Patent Classification (IPC) or to both national classification and IPC

| B. | FIELDS SEARCHED |
| --- | --- |

Minimum documentation searched (classification system followed by classification symbols)

H01M 4/36(2006.01); H01M 10/052(2010.01); H01M 4/505(2010.01); H01M 4/525(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 단입자(single particle), 리튬 니켈계 산화물(lithium nickel oxide), 코팅층(coating layer), 1차 코팅(primary coating), 2차 코팅(secondary coating), 도트 형상(dot form), 층상(layer), 양극 활물질(cathode active material)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X<br>Y<br>A | BAO, Wenda et al. Simultaneous enhancement of interfacial stability and kinetics of single-crystal LiNi0.6Mn0.2Co0.2O2 through optimized surface coating and doping. Nano Letters. 25 November 2020, vol. 20, pp. 8832-8840.<br>    See abstract; and pages 8832, 8833, 8837 and 8838. | 1-4,7,9,12,13<br>5,6,8<br>10,11 |
| Y | KR 10-2023-0153983 A (LG ENERGY SOLUTION, LTD.) 07 November 2023 (2023-11-07)<br>    See paragraphs [0008] and [0138]; and claims 1 and 2. | 5,6,8 |
| A | REISSIG, Friederike et al. Synergistic effects of surface coating and bulk doping in Ni-rich lithium nickel cobalt manganese oxide cathode materials for high-energy lithium ion batteries. ChemSusChem. 02 December 2021 (online), vol. 15, e202102220, pp. 1-11.<br>    See entire document. | 1-13 |

| ✓ Further documents are listed in the continuation of Box C. | ✓ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **19 March 2025** | **19 March 2025** |

| Name and mailing address of the ISA/KR | Authorized officer |
| --- | --- |
| **Korean Intellectual Property Office**<br>**Government Complex-Daejeon Building 4, 189 Cheongsa-**<br>**ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/020493** |

| C. | DOCUMENTS CONSIDERED TO BE RELEVANT | |
| --- | --- | --- |
| Category* | Citation of document, with indication, where appropriate, of the relevant passages | Relevant to claim No. |
| A | KR 10-2023-0095271 A (POSCO HOLDINGS INC. et al.) 29 June 2023 (2023-06-29)<br>See entire document. | 1-13 |
| A | KR 10-2022-0097196 A (ECOPRO BM CO., LTD.) 07 July 2022 (2022-07-07)<br>See entire document. | 1-13 |

Form PCT/ISA/210 (second sheet) (July 2022)

## INTERNATIONAL SEARCH REPORT
### Information on patent family members

International application No.

**PCT/KR2024/020493**

| Patent document cited in search report | | | Publication date (day/month/year) | Patent family member(s) | | | Publication date (day/month/year) |
|---|---|---|---|---|---|---|---|
| KR | 10-2023-0153983 | A | 07 November 2023 | CN | 111164806 | A | 15 May 2020 |
| | | | | CN | 111164806 | B | 21 April 2023 |
| | | | | CN | 116154148 | A | 23 May 2023 |
| | | | | EP | 3680968 | A1 | 15 July 2020 |
| | | | | EP | 3680968 | A4 | 18 November 2020 |
| | | | | EP | 4250404 | A2 | 27 September 2023 |
| | | | | EP | 4250404 | A3 | 06 December 2023 |
| | | | | JP | 2020-520539 | A | 09 July 2020 |
| | | | | JP | 6929588 | B2 | 01 September 2021 |
| | | | | KR | 10-2019-0059241 | A | 30 May 2019 |
| | | | | KR | 10-2656223 | B1 | 11 April 2024 |
| | | | | KR | 10-2687546 | B1 | 24 July 2024 |
| | | | | US | 11594727 | B2 | 28 February 2023 |
| | | | | US | 11909045 | B2 | 20 February 2024 |
| | | | | US | 11967714 | B2 | 23 April 2024 |
| | | | | US | 2020-0295367 | A1 | 17 September 2020 |
| | | | | US | 2023-0163295 | A1 | 25 May 2023 |
| | | | | US | 2023-0352678 | A1 | 02 November 2023 |
| | | | | US | 2024-0234719 | A1 | 11 July 2024 |
| | | | | WO | 2019-103458 | A1 | 31 May 2019 |
| KR | 10-2023-0095271 | A | 29 June 2023 | CN | 118435379 | A | 02 August 2024 |
| | | | | EP | 4456188 | A1 | 30 October 2024 |
| | | | | WO | 2023-121147 | A1 | 29 June 2023 |
| KR | 10-2022-0097196 | A | 07 July 2022 | CN | 116325218 | A | 23 June 2023 |
| | | | | EP | 4220773 | A1 | 02 August 2023 |
| | | | | JP | 2023-546101 | A | 01 November 2023 |
| | | | | US | 2023-0238530 | A1 | 27 July 2023 |
| | | | | WO | 2022-145693 | A1 | 07 July 2022 |

Form PCT/ISA/210 (patent family annex) (July 2022)

**EP 4 730 428 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230190391
- KR 1020240137158